# EUROPÄISCHE PATENTANMELDUNG

(11) **EP 1 107 322 A2**
(43) Veröffentlichungstag der Anmeldung: **13.06.2001**
(21) Anmeldenummer: 00811047.0
(22) Anmeldetag: 08.11.2000
(51) Int. Cl.: H01L 39/14, H01L 39/24

(54) **Hochtemperatursupraleiteranordnung und Verfahren zu deren Herstellung**

(30) Priorität: 02.12.1999 DE 19957981
(71) Anmelder: ABB RESEARCH LTD., 8050 Zürich (CH)
(72) Erfinder: Chen, Makan, 5405 Baden-Dättwill (CH); Paul, Willi, 5430 Wettingen (CH)
(74) Vertreter: ABB Patent Attorneys

(57) **Zusammenfassung**

Die vorliegende Erfindung hat eine Hochtemperatursupraleiteranordnung zum Gegenstand, welche vor Hot-Spots geschützt ist. Zwischen einer supraleitenden Schicht 1 und einem elektrischen Bypass 2 ist eine Kontaktierungsschicht 4 vorgesehen, welche eine anisotrope elektrische Leitfähigkeit aufweist. Dadurch wird ein geringer Kontaktwiderstand zwischen dem Supraleiter 1 und dem Bypass 2 gewährleistet, ohne dass die Admittanz in der Hauptstromflussrichtung 3 erhöht wird. Vorteilhafterweise wird die genannte Anisotropie durch Diskontinuitäten in der Kontaktierungsschicht 4 erzeugt, beispielsweise indem Letztere in untereinander nicht verbundene Bereiche 41 zerfällt.

Weiter wird ein zweistufiges Verfahren zur Herstellung einer erfindungsgemässen Anordnung angegeben. Dabei wird zuerst die Kontaktierungsschicht 4 mittels Co- oder Post-Sinter Prozessen auf den Supraleiter 1 aufgetragen und anschliessend über eine Zwischenschicht 5 mit dem Bypass 2 verklebt oder verlötet.

## Beschreibung

### TECHNISCHES GEBIET

Die vorliegende Erfindung bezieht sich auf das Gebiet der Hochtemperatursupraleiter. Sie betrifft eine Hochtemperatursupraleiteranordnung gemäss dem Oberbegriff des Patentanspruchs 1 sowie ein Verfahren zu deren Herstellung gemäss dem Oberbegriff des Patentanspruchs 8.

### STAND DER TECHNIK

Bei Anwendungen von Hochtemperatursupraleitern für hohe elektrische Leistungen muss die Problematik der sogenannten "Hot-Spots" berücksichtigt werden. Infolge von unvermeidlichen Materialinhomogenitäten im Supraleiter oder wegen lokalen thermischen Fluktuationen ist die kritische Stromdichte nicht über den ganzen Supraleiter konstant. Folglich wird beispielsweise infolge eines Kurzschlusses bei einem anfänglichen Ansteigen des Fehlerstromes die Stromdichte an der schwächsten Stelle des Supraleiters die lokale kritische Stromdichte zuerst überschreiten. An dieser Stelle des Supraleiters beginnt sich also ein Spannungsabfall aufzubauen. Dabei wird Joule'sche Wärme erzeugt, welche den Supraleiter in einem kleinen Bereich aufheizt und die Supraleitung lokal zusammenbrechen lässt. Es entsteht ein Hot-Spot welcher letztendlich zu einer Zerstörung des Supraleiters führt.

Erste Abhilfe bietet ein elektrischer Bypass, welcher über die ganze Länge eines Hochtemperatursupraleiters mit diesem in elektrischem Kontakt steht und somit parallel zu jedem potentiellen Hot-Spot liegt. Der elektrische Bypass stellt einen alternativen Strompfad dar, durch welchen der Kurschlussstrom den Hot-Spot umgehen kann, wodurch die Spannungsverteilung homogenisiert wird.

Um den Supraleiter effizient vor Hot-Spots zu schützen muss die Bypassschicht eine gewisse Mindestleitfähigkeit aufweisen. Wird der Supraleiter jedoch in einem Strombegrenzer eingesetzt, ist zur Gewährleistung der geforderten Begrenzungseigenschaften ein bestimmter minimaler Gesamt-Bypasswiderstand erforderlich. Um die Leiterlänge des Strombegrenzers nicht übermässig anwachsen zu lassen, darf somit der Bypasswiderstand pro Länge nicht zu klein sein. Der Bypass darf also nicht zu gut leiten oder muss einen entsprechend geringen Querschnitt aufweisen.

Die EP 0 911 889 A2 setzt sich zur Aufgabe, in Strombegrenzern für elektrische Leistungen von mehr als 1MW Hot-Spots zu verhindern. Die dazu vorgeschlagene Anordnung umfasst eine Supraleiterschicht, welche über eine Hauptfläche mit zwei normalleitenden Bypassschichten in Kontakt steht. Die erste, Nichtedelmetall-Bypassschicht besteht aus Stahl und dient gleichzeitig als Wärmesenke. Die zweite, edelmetallhaltige Bypassschicht besteht aus Silber oder einer Silberlegierung, auf welche die Stahlschicht aufgelötet ist. Um den Gesamt-Bypasswiderstand nicht zu klein werden zu lassen, muss die zweite Bypassschicht möglichst dünn sein oder durch Zulegieren von Gallium oder Blei auf einen erhöhten spezifischen Widerstand gebracht werden.

Ferner ist in der DE-OS 196 34 424 A1 ein Verfahren zur Herstellung eines Leiterverbundes aus einem Hochtemperatursupraleiter und einer Bypassschicht offenbart. Eine Silberfolie wird dabei auf eine Inertpulverschicht aufgebracht und mit einer sogenannten Grünfolie bedeckt, welche ein oxidkeramisches Pulver als Ausgangsmaterial für den Hochtemperatursupraleiter und einen organischen Binder enthält. Anschliessend werden die Schichten schmelzprozessiert, d.h. nach einem Ausbrennen des Binders erfolgt ein partielles Schmelzen des Pulvers. Dabei löst sich das Silber teilweise im flüssigen Hochtemperatursupraleiter und nimmt die Dicke der Silberschicht in unkontrollierter Weise ab. Es ergibt sich ein ausgezeichneter Kontaktwiderstand zwischen der Silber- und der Supraleiterschicht von weniger als 1 µΩcm² bei 77K. Zur mechanischen Stabilisierung wird noch mindestens eine Schicht aus einem Faserverbundwerkstoff aufgebracht.

### DARSTELLUNG DER ERFINDUNG

Aufgabe der vorliegenden Erfindung ist es, bei einer Hochtemperatursupraleiteranordnung der eingangs genannten Art den Kontakt zwischen dem elektrischen Bypass und dem Supraleiter zu verbessern ohne dabei die Leitfähigkeit der Anordnung wesentlich zu erhöhen. Diese Aufgabe wird durch eine Hochtemperatursupraleiteranordnung mit den Merkmalen des Patentanspruchs 1 sowie durch ein Verfahren zu deren Herstellung mit den Merkmalen des Patentanspruchs 8 gelöst.

Kern der Erfindung ist es, den elektrischen Bypass über eine Kontaktierungsschicht an den Supraleiter zu koppeln, welche sich durch eine anisotrope, vorwiegend in einer Richtung senkrecht zur Hauptstromflussrichtung beziehungsweise zu den Leitern der Anordnung ausgeprägte Leitfähigkeit auszeichnet. Dadurch wird eine Kommutierung des Stromes vom Supraleiter in den Bypass ermöglicht, ohne dass der Gesamtwiderstand von Bypass und Kontaktierungsschicht herabgesetzt wird.

Gemäss einer ersten bevorzugten Ausführungsform wird die Anisotropie der Leitfähigkeit dadurch erzielt, dass die Kontaktierungsschicht nicht durchgehend ist, d.h. sie wird durch quer zur Hauptstromflussrichtung verlaufende Diskontinuitäten unterbrochen und zerfällt beispielsweise in mehrere Streifen.

Gemäss einer weiteren Ausführungsform ist die Kontaktierungsschicht eine mehr oder weniger gleichmässige Verteilung von einzelnen, untereinander nicht verbundenen Inseln.

Die genannten zwei Ausführungen haben den Vorteil, dass die Dicke der Kontaktierungsschicht deren Leitfähigkeit in Hauptstromflussrichtung nicht beeinflusst und erstere somit aus einem sehr guten und isotropen Leiter bestehen kann. Dadurch ist es möglich, als Materialien für die Kontaktierungsschicht Silber oder Gold zu wählen, welche in einem Sinter- oder Anlassprozess einen niederohmigen Kontakt zum Supraleiter bilden können, ohne dabei dessen Eigenschaften zu beeinträchtigen.

In einer dritten Ausführungsform ist eine weitere, durchgehende Übergangsschicht zwischen der Kontaktierungsschicht und dem elektrischen Bypass vorgesehen.

Die Vorteile des erfindungsgemässen Verfahrens liegen darin, dass die Präparation der Kontaktierungsschicht vom Vorgang der Aufbringung des elektrischen Bypass getrennt wird. Die zur Erzielung eines guten Kontaktwiderstandes zwischen Supraleiter und Kontaktierungsschicht geeigneten Co- oder Post-Sinter Prozesse werden vorgängig ausgeführt und beeinträchtigen die elektrischen Eigenschaften des Bypasses nicht.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen in nicht massstabsgetreuer Abbildung
Fig.1 einen Ausschnitt aus einer Hochtemperatursupraleiteranordnung gemäss einer ersten Ausführungsform der Erfindung und
Fig.2 einen Ausschnitt aus einer Hochtemperatursupraleiteranordnung gemäss einer zweiten Ausführungsform der Erfindung.

In beiden Zeichnungen zeigt die hintere Hälfte der Darstellung die vollständige Anordnung, währenddem der vordere Teil dem Zustand nach dem ersten erfindungsgemässen Prozessschritt entspricht.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

Für die in den Zeichnungen dargestellte Hochtemperatursupraleiteranordnung und die nun folgende, sich darauf beziehende Beschreibung wurde eine planare Geometrie gewählt, wie sie beispielsweise für supraleitende Strombegrenzer der eingangs genannten Art verwendet wird. Eine analoge Schichtabfolge findet sich auch in radialer Richtung in supraleitenden Hohlzylindern. Die Erfindung ist aber keineswegs auf die genannten Geometrien begrenzt und kann genausogut bei Drähten oder Filamenten mit einem supraleitenden Kern, welcher von einem elektrischen Bypass umgeben ist, Verwendung finden. Ebensowenig ist eine erfindungsgemässe Anordnung auf den Einsatz in Strombegrenzern beschränkt, sondern kann auch in Transformatoren oder Kabeln eingesetzt werden.

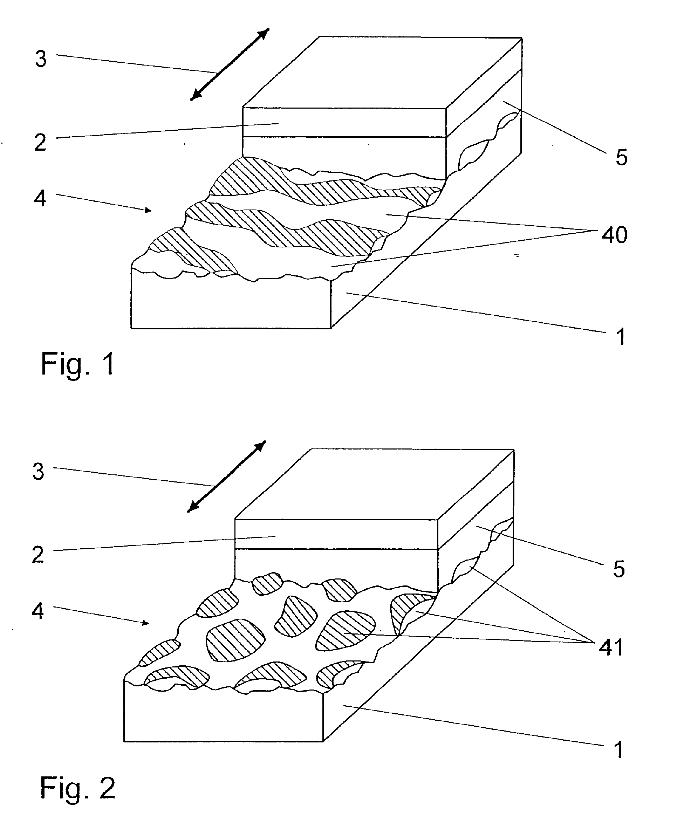

Der in Fig.1 dargestellte Schnitt durch eine Hochtemperatursupraleiteranordnung nach der Erfindung zeigt eine supraleitende Schicht 1, einen mit der supraleitenden Schicht 1 in elektrischem Kontakt stehenden elektrischen Bypass 2 und eine Hauptstromflussrichtung 3, in welcher der Strom durch den Leiterverbund aus Supraleiter 1 und Bypass 2 fliesst. Zwischen Supraleiter und Bypass ist eine Kontaktierungsschicht 4 vorgesehen, welche den elektrischen Kontakt zur keramischen Hochtemperatursupraleiterschicht 1 sicherstellt und sich durch eine anisotrope Leitfähigkeit auszeichnet. Zwischen der Kontaktierungsschicht 4 und dem Bypass 2 kann sich eine weitere Übergangsschicht 5 befinden, welche zur mechanischen Fixierung und elektrischen Kontaktierung des Bypasses dient.

Die Kontaktierungsschicht 4 sorgt für einen niederohmigen Kontaktwiderstand zwischen dem Supraleiter 1 und seinem elektrischen Bypass 2. Dies gewährleistet eine problemlose Kommutierung des Stromes in die Bypassschicht, sobald sich der Supraleiter lokal aufzuheizen und einen Widerstand auszubilden beginnt. Dank dem zum potentiellen Hot-Spot parallelen Strompfad durch den Bypass wird die Energiedissipation im Supraleiter rechtzeitig gebremst. Die Kontaktierungsschicht 4 weist erfindungsgemäss eine anisotrope Leitfähigkeit auf, damit sie nicht gleichzeitig selbst einen Bypass bildet, welcher möglicherweise den eigentlichen Bypass 2 konkurrenziert und die Gesamtleitfähigkeit in unkontrollierter Weise erhöht. Die Leitfähigkeit der Kontaktierungsschicht 4 ist in Hauptstromflussrichtung 3 gegenüber einer Richtung senkrecht zu den Leiterebenen in Fig.1 stark reduziert.

Die Anisotropie der Leitfähigkeit der Kontaktierungsschicht 4 kann eine intrinsische Eigenschaft des verwendeten Materials sein, beispielsweise bei Graphit. Der geforderte hohe Widerstand in Hauptstromflussrichtung 3 kann auch durch die topologische Ausgestaltung der Kontaktierungsschicht 4 erzielt werden. Dies geschieht am einfachsten dadurch, dass die Kontaktierungsschicht 4 keine durchgehende Schicht bildet, den Supraleiter 1 also nicht vollständig überdeckt. Die Kontaktierungsschicht 4 ist in mehr oder weniger regelmässigen Abständen durch Diskontinuitäten 40 unterbrochen, welche annähernd senkrecht zur Hauptstromflussrichtung 3 verlaufen. In Fig.2 sind die Diskontinuitäten selbst untereinander verbunden, somit zerfällt die Kontaktierungsschicht 4 in einzelne, untereinander n-icht verbundene Bereiche oder Inseln 41.

Die Übergangsschicht 5 dient der Fixierung des Bypass 2 und zum Ausgleich eventueller Unebenheiten in den zu kontaktierenden Oberflächen von Supraleiter- und Bypassschicht. Diese zweite Schicht 5 umfasst ein tiefschmelzendes Lot oder einen leitenden Kunstoff wie beispielsweise ein mit leitenden Partikeln angereichertes Epoxidharz. Es ist zu beachten, dass die erforderliche Qualität des Kontaktwiderstandes zwischen der Supraleiterkeramik und dem Bypass bevorzugt durch Prozesse ermöglicht wird, bei welchen das Material der Kontaktierungsschicht 4 sich teilweise im Supraleiter 1 löst beziehungsweise in diesen hineindiffundiert oder -wächst. Nur Edelmetalle wie Silber und Gold oder deren Legierungen führen bei einer solchen Behandlung nicht zu einer Degradation des Supraleiters 1. Die direkte Aufbringung des Bypass 2 mittels einer Übergangsschicht 5 ohne Kontaktierungsschicht 4 ist wegen der Oberflächenbeschaffenheit des keramischen Supraleiters 1 für einen guten Kontakt nicht ausreichend.

Die vorgeschlagene Lösung ist genauso wie das zugrundeliegende Problem der Hot-Spots nicht auf einen bestimmten Hochtemperatursupraleiter-Typ und/oder ein bestimmtes Verfahren zu seiner Herstellung beschränkt. Bei Strombegrenzeranwendungen unter Verwendung von schmelzprozessiertem Bi₂Sr₂CaCu₂O₈ sind für die erfindungsgemässe Anordnung Schichtdicken vorzugsweise zwischen 50 und 1000 µm für den Supraleiter, 10-100 µm für die Übergangsschicht 5 und 1-20 µm für die Kontaktierungsschicht 4 denkbar. Die Diskontinuitäten 40, welche einzelne Bereiche der Kontaktierungsschicht 4 trennen, haben Linearausdehnungen von typischerweise 10-50 µm. Die Inseln 41 weisen vorzugsweise eine Ausdehnung von weniger als 1000 µm und einen gegenseitigen Abstand in derselben Grössenordnung auf. Unter der Annahme kreisrunder, hexagonal angeordneter Inseln 41 liegt die Perkolationsgrenze bei einem Überdekkungsgrad von 90%, welcher somit nicht überschritten werden sollte. Als normalleitender Bypass 2 geeignet sind metallische Legierungen auf Stahl- oder Nickelbasis mit einem spezifischen Widerstand bei Raumtemperatur von mehr als 10 µΩcm. Der resultierende Kontakt- oder Übergangswiderstand zwischen Supraleiter 1 und Bypass 2 liegt bei weniger als 1 µΩcm².

Das erfindungsgemässe Verfahren zur Herstellung der oben beschriebenen Hochtemperatursupraleiteranordnung setzt sich aus mindestens zwei getrennten Schritten zusammen. Zuerst wird die erste Kontaktierungsschicht 4 auf den Supraleiter 1 aufgebracht und anschliessend wird der Bypass 2, eventuell mittels einer Übergangsschicht 5, in elektrischem und mechanischem Kontakt mit dem Supraleiter 1 fixiert. In den Zeichnungen ist die im Aufbau begriffene Anordnung, wie sie sich nach dem ersten Schritt präsentiert, jeweils in der vorderen Hälfte dargestellt. Die Präparation der Kontaktierungsschicht 4 zwecks Gewährleistung eines kleinen Übergangswiderstandes findet vorzugsweise bei hohen Prozesstemperaturen von 800-900°C statt, bei welchen ein metallischer Bypass 2 oxidieren würde. Erfindungsgemäss ist dieser erste Schritt bereits abgeschlossen zum Zeitpunkt der bei vergleichsweise tiefen Temperaturen von 100-300°C erfolgenden Fixierung des Bypass 2. Die vorhergehend eingestellten elektrischen Eigenschaften des Bypass 2 sowie des Supraleiters 1 werden durch den zweiten Kontaktierprozess somit nicht mehr beeinflusst.

Die Aufbringung der Kontaktierungsschicht 4 im ersten Schritt kann grundsätzlich in einem Co-Sinter oder einem Post-Sinter Verfahren erfolgen.

Falls der Supraleiter 1 mittels partiellem Schmelzen aus einer sogenannten Grünfolie hergestellt wird, kann die Kontaktierungsschicht 4 gleichzeitig mit dem Supraleiter 1 präpariert werden. Dazu wird eine dünne und oder mit Löchern versehene Folie aus Silber auf die Grünfolie aufgelegt oder ein Silberpulver aufgesprüht oder mittels eines Siebes gleichmässig auf die Grünfolie verteilt. Nach dem Sinterprozess bei annähernd 900°C verbleibt eine diskontinuierliche Schicht beziehungsweise eine mehr oder weniger gleichmässige Verteilung von Inseln auf der Oberfläche des Supraleiters 1 zurück. Alternativ dazu kann das Silber auch als dreidimensional vernetztes Gewebe in einer Grünfolie mit einer geeigneten Konsistenz eingetaucht werden. Nach dem Volumenverlust der Grünfolie im Sinterprozess tauchen Abschnitte des Silbernetzwerks an der Oberfläche der Keramik auf und ermöglichen eine niederohmige Kontaktierung des Supraleiters.

In einem anderen Co-Sinter Verfahren wird ein in den Figuren nicht dargestelltes Silbersubstrat, auf welchem sich die Grünfolie während dem partiellen Schmelzen befindet, zur Kontaktierung weiterverwendet. Dieses Substrat, welches normalerweise wegen seiner exorbitanten Leitfähigkeit nach dem Sintern abgelöst wird, muss zu diesem Zweck durch einen elektrochemischen Aetzprozess verdünnt werden.

In einem sogenannten Post-Sinter Prozess wird die angehende Kontaktierungsschicht 4 auf den fertig gesinterten Supraleiter 1 wiederum als Folie oder Pulver aufgebracht. Ebenfalls möglich ist es, Silberpartikel in einem organischen Binder zu suspendieren und auf den Supraleiter aufzupinseln, aufzuspritzen oder im Foliengiessverfahren zu verteilen. Weiter sind zur Auftragung einer feinen Silberschicht Verfahren wie elektrolytische Abscheidung, Plasma- oder Flammspritzen oder Vakuumverfahren (Chemical Vapor Deposition (CVD), Kathodenzerstäubung (sputtering) oder Molekularstrahlablagerung (Cluster Deposition)) denkbar. Anschliessend folgt ein Anlassen (post-annealing) bei bis zu 850°C, woraus wiederum ein ausgezeichneter elektrischer Kontakt zum Supraleiter 1 resultiert.

Im 2. Prozessschritt wird der Bypass mit dem Supraleiter in Kontakt gebracht. Dies kann durch mechanisches Andrücken erfolgen oder über eine zweite Kontaktierungs- oder Übergangsschicht 5. Es bieten sich dazu Lot- oder Klebverfahren an, welche eine einmalige Erwärmung respektive ein Aushärten unter Vakuum bei 100-300°C erfordern.

Beim erstgenannten Verfahren wird eine dünne Lotschicht auf den Bypass 2 aufgetragen und daraufhin mit dem Supraleiter 1 in Kontakt gebracht. Beim zweiten Verfahren wird ein leitender Kunststoff wie z.B. Epoxidharz mit Silberpartikeln zum Zusammenkleben verwendet. Das Harz wird aufgesprayt oder im Siebdruckverfahren aufgetragen und gleichmässig verteilt. Die Bypassschicht kann vorgängig noch mit einer Zinn-, Silber-oder Goldlage beschichtet werden.

### BEZUGSZEICHENLISTE

- 1: Supraleiter
- 2: elektrischer Bypass
- 3: Hauptstromflussrichtung
- 4: Kontaktierungsschicht
- 40: Diskontinuität
- 41: Inseln
- 5: Übergangsschicht

## Patentansprüche

1. Hochtemperatursupraleiteranordnung mit einem Hochtemperatursupraleiter (1) und einem elektrischen Bypass (2), welcher mit dem Hochtemperatursupraleiter (1) in elektrischem Kontakt steht, wobei der Strom in einer Hauptstromflussrichtung (3) durch die Anordnung fliesst,
dadurch gekennzeichnet, dass zwischen dem Supraleiter (1) und dem Bypass (2) eine Kontaktierungsschicht (4) vorgesehen ist, welche eine anisotrope, in Hauptstromflussrichtung (3) verringerte elektrische Leitfähigkeit aufweist.

2. Anordnung nach Anspruch 1, dadurch gekennzeichnet, dass, die Kontaktierungsschicht (4) in Hauptstromflussrichtung (3) diskontinuierlich ist und den Supraleiter (1) nicht vollständig überdeckt.

3. Anordnung nach Anspruch 1, dadurch gekennzeichnet, dass die Kontaktierungsschicht (4) aus einzelnen Inseln (41) besteht.

4. Anordnung nach Anspruch 3, dadurch gekennzeichnet, dass die Kontaktierungsschicht (4) den Supraleiter (1) zu maximal 90% überdeckt.

5. Anordnung nach einem der Ansprüche 1 - 4, dadurch gekennzeichnet, dass eine Übergangsschicht (5) zwischen der Kontaktierungsschicht (4) und dem Bypass (2) angeordnet ist.

6. Anordnung nach Anspruch 5, dadurch gekennzeichnet, dass die Übergangsschicht (5) einen leitenden Kunststoff oder ein Lot aufweist.

7. Anordnung nach einem der Ansprüche 1 - 6, dadurch gekennzeichnet, dass die Kontaktierungsschicht (4) aus Silber oder einer Silberlegierung besteht.

8. Verfahren zum Aufbau einer Hochtemperatursupraleiteranordnung nach Anspruch 1, dadurch gekennzeichnet, dass in einem ersten Schritt eine Kontaktierungsschicht (4) mit einer in einer Hauptstromflussrichtung (3) verringerten elektrischen Leitfähigkeit auf einen Hochtemperatursupraleiter (1) aufgebracht wird und in einem zweiten Schritt ein elektrischer Bypass (2) in Kontakt mit der Kontaktierungsschicht (4) gebracht wird.

9. Verfahren nach Anspruch 8, dadurch gekennzeichnet, dass der erste Schritt ein Co-Sinter Prozess oder ein Post-Sinter Prozess ist.

10. Verfahren nach Anspruch 8, dadurch gekennzeichnet, dass der zweite Schritt das Aufkleben des elektrischen Bypasses (2) mittels eines leitendes Kunststoffes oder das Auflöter des elektrischen Bypasses (2) umfasst.
